# EUROPEAN PATENT SPECIFICATION

(11) **EP 1 218 934 B1**
(45) Date of publication and mention of the grant of the patent: **20.12.2006**
(21) Application number: 00964248.9
(22) Date of filing: 28.09.2000
(51) Int. Cl.: H01L 21/66, H01J 37/32

(54) **METHOD FOR DETERMINING THE ENDPOINT OF ETCH PROCESS STEPS**
ENDPUNKTKONTROLLE BEI ÄTZSCHRITTEN
PROCEDE DE DETERMINATION DE L'EXTREMITE D'ETAPES DE GRAVURE

(30) Priority: 30.09.1999 EP 99119443
(43) Date of publication of application: 03.07.2002
(73) Proprietor: Qimonda Dresden GmbH & Co. oHG, 01099 Dresden (DE); Qimonda AG, 81739 München (DE); MOTOROLA, INC., Schaumburg, IL 60196 (US)
(72) Inventor: PETRUCCI, Joseph, Louis, Austin, TX 78734 (US); MORGENSTERN, Thomas, 01109 Dresden (DE)
(74) Representative: Epping - Hermann - Fischer
(86) International application number: PCT/EP2000/009518
(87) International publication number: WO 2001/024254

(56) References cited:
- EP-A- 0 294 873
- EP-A- 0 679 948
- US-A- 4 680 084
- HENCK ET AL: "Insitu spectral ellipsometry for real-time thickness measurement : etching multilayer stacks" JOURNAL OF VACUUM SCIENCE AND TECHNOLOGY: PART A., vol. 11, no. 4, August 1993 (1993-08), pages 1179-1183, XP000403723 AMERICAN INSTITUTE OF PHYSICS. NEW YORK., US ISSN: 0734-2101

## Description

The invention is directed to a method for determining the endpoint of etch process steps e.g. during recess etch steps of wafers by way of an optical endpoint determination system which is applied to a vacuum etch chamber within the etch steps are carried out.

### DESCRIPTION OF THE PRIOR ART

Several etch process steps such as the recess 2 and recess 3 steps are carried out within a vacuum chamber or a chamber with a low internal pressure. The vacuum chamber is normally provided with a plasma source for ionizing an etching gas which is introduced in the chamber. At front end of an etch step it is necessary to provide a wafer with an etch mask such as PAD nitride.

Many product types incorporate process steps which require blind etches which stop within a film layer, such processes include Recess Etches and Shallow Trench Isolation. The use of an endpoint measuring system has improved achieving the target depths. The chamber is further provided with a dome to separate the vacuum chamber from the environment. For this measuring system this dome has a window for determining the endpoint of the etching process at its top end. Such an endpoint determining system is an optical system which monitors the etch process and incorporates an interferometric measuring system which determines the depth of the etched recesses or trenches in a semiconductor wafer positioned in the chamber on the top of a base.

The target depths are referenced from the silicon surface which is usually below a masking layer (PAD nitride). The problem is that the masking layer can vary from lot to lot or from wafer to wafer. The problem regarding the endpoint determination system is therefore that Interferometric Endpoint measuring systems (IEP) are able to determine the depth of a hole or a trench but the depth which is determined is not the target depth. The measured depth is depending from the thickness of the masking layer on the top surface of the silicon. Therefore the depth of e.g. recess 2 and recess 3 varies depending from the thickness of the masking layer.

For this reason a film measurement step is required to obtain the necessary offset required to setup the IEP. This number is either the measurement of one wafer or the average of several wafers. The current endpoint systems allow for ony one input per lot.

In J. Vac. Sci and Technol. A, vol. 11, n°4, pages 1179-1185 is disclosed the use of ellipsometry to monitor etching in poly-buffered LOCOS process.

### SUMMARY OF THE INVENTION

It is an object of the present invention to provide a method for determining the endpoint of an etch process step during recess etch steps which eliminates the influence of different thickness of the masking layer.

Another object of the present invention is to minimize the necessary tool adaption.

A further object of the present invention is to provide a method which can be used on all etches which must stop in the film being etched and not at an interface.

It is also an object of the invention to provide a method which is capable for 300 mm wafers and future embodiments.

In accordance with one object of the invention there is provided a method for determining the endpoint of etch process steps as defined in claim 1.

This new method eliminates the influences of different thickness of the masking layer and can be used on all etches which must stop in the film being etched and not at an interface.
Also the necessary tool adaption is minimized.

The measuring step is carried out with a laser measurement system which is based on ellipsometry.

To minimize the time for the measuring step this step is carried out with the laser measuring system which is preferably directed to the centre of the wafer.

The layer on top of the wafer is preferably a nitride layer, e. g. a PAD nitride layer.

The new method is capable for 300 mm wafers and future embodiements.

### BRIEF DESCRIPTION OF THE DRAWINGS

- Fig. 1: illustrates schematically the depth of an etched trench with the target depth and the IEP target; and
- Fig. 2: illustrates schematically the new method for determining the endpoint of etch steps e.g. during recess etch steps of wafers.

### DETAILED DESCRIPTION OF THE INVENTION

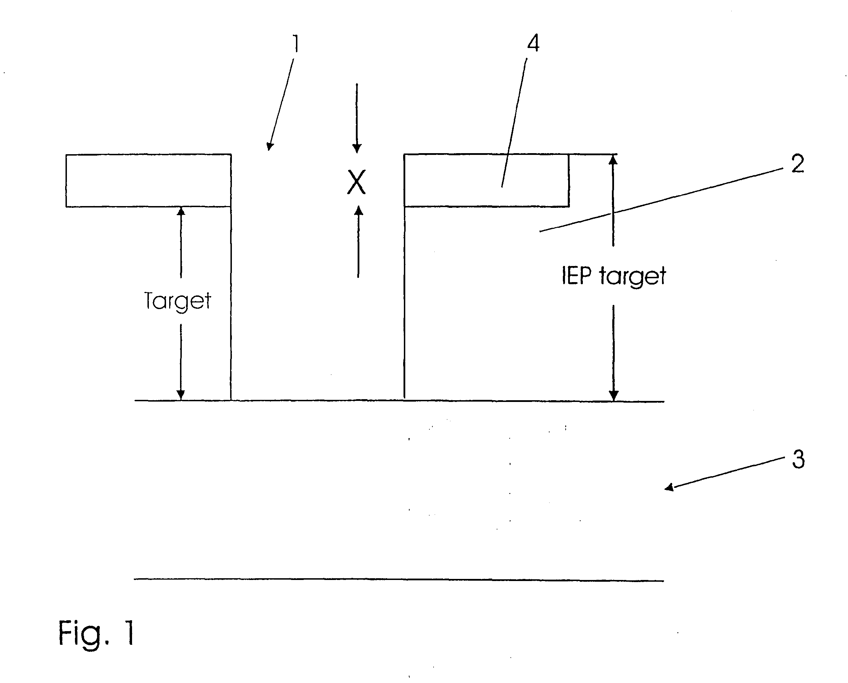

Figure 1 illustrates schematically the depth of an etched hole 1 e.g. a trench with the target depth within a poly Si layer 2. This target depth is the ideal depth which is necessary to built up a functional element within the wafer 3. To determine the endpoint of an etch process the mentioned Interferometric Endpoint measuring systems 6 are used. This IEP systems are able to determine the depth of a hole 1 or a trench but the depth that is determined is not the target depth. From Figure 1 it is to be seen that the determinable depth is a sum of the thickness x of the PAD nitride layer 4 and the target depth. If the thickness of the PAD nitride layer 4 is unknown then the measured depth at the endpoint is equal to the target depth and therefore the etched hole 1 or trench is not deep enough.

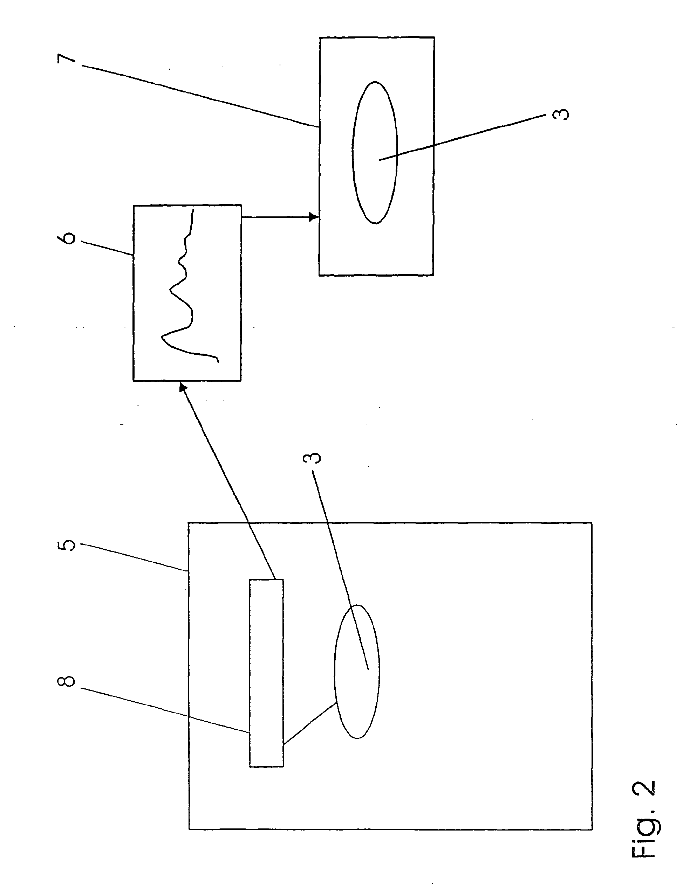

According to Figure 2 there is introduced an additional step which is carried out in parallel to the alignment stage 5 in the front end of the etch process 7. This additional step covers a thickness measuring step to determine the thickness of the PAD nitride 4 of each wafer 3 introduced to the etch process 7.

This measuring step which is carried out by a laser measurement system 8 based on ellipsometry determines the thickness of the PAD nitride 4 on the top of the wafer 3 first and then the measurement (film thickness data) is forwarded to the endpoint determination system. In this endpoint determination system (IEP) the measurement is added to the target of the endpoint algorithm. The current etch step is stopped if the target depth plus the value of the measurement is reached.

To minimize the time for the measuring step this step is carried out with the laser measuring system which is directed to the centre of the wafer 3.

The new method provides a wafer to wafer endpoint target determination through PAD-nitride thickness measurement in parallel to wafer alignment which eliminates the influences of different thickness of the masking layer and can be used on all etches which must stop in the film beeing etched and not at an interface.

## Claims

1. Method for determining the endpoint of an etch step during a recess etch of a semiconductor wafer having a mask layer on top of a substrate in a vacuum etch chamber, the method comprising the steps of:
- performing a wafer alignment in the front end of the etch step;
- measuring the thickness of the mask layer on top of the wafer using a laser measurement system, which performs ellipsometry, while performing the wafer alignment step to determine a thickness value representing the thickness of the mask layer;
- forwarding the thickness value to an interferometric endpoint determination system performing an endpoint algorithm;
- adding the thickness value to a target depth value of the endpoint algorithm;
- etching a recess into the substrate relative to a mask provided by the mask layer;
- measuring the depth of the recess during the etch step to obtain a depth value representing the depth of the recess;
- wherein the etch step is stopped when the depth value reaches the sum of the target depth value and the thickness value.

2. Method according to claim 1, **characterized in that** the step of measuring the thickness is carried out with the laser measuring system which is directed to the centre of the wafer.

3. Method according to any of claims 1 to 2, **characterized in that** the mask layer is a nitride (4) layer.

## Patentansprüche

1. Verfahren zum Bestimmen des Endpunkts eines Ätzschritts während einer Ausnehmungsätzung eines Halbleiterwafers mit einer Maskenschicht auf einem Substrat in einer Vakuumätzkammer, wobei das Verfahren die folgenden Schritte umfaßt:
- Durchführen einer Waferausrichtung im Vorfeld des Ätzschritts;
- Messen der Dicke der Maskenschicht auf dem Wafer und Verwendung eines Lasermeßsystems, das Ellipsometrie durchführt, während der Waferausrichtungsschritt ausgeführt wird, um einen die Dicke der Maskenschicht darstellenden Dickewert zu bestimmen;
- Weiterleiten des Dickewerts an ein einen Endpunktalgorithmus ausführenden interferometrisches Endpunktbestimmungssystem;
- Addieren des Dickewerts zu einem Zieltiefenwert des Endpunktalgorithmus;
- Ätzen einer Ausnehmung in das Substrat relativ zu einer von der Maskenschicht bereitgestellten Maske;
- Messen der Tiefe der Ausnehmung während des Ätzschritts, um einen die Tiefe der Ausnehmung darstellenden Tiefewert zu erhalten;
- wobei der Ätzschritt gestoppt wird, wenn der Tiefenwert die Summe des Zieltiefenwerts und des Dickenwerts erreicht.

2. Verfahren nach Anspruch 1, **dadurch gekennzeichnet, daß** der Schritt des Messens der Dicke mit dem Lasermeßsystem durchgeführt wird, das auf die Mitte des Wafers gerichtet ist.

3. Verfahren nach einem der Ansprüche 1 bis 2, **dadurch gekennzeichnet, daß** die Maskenschicht eine Nitrid-(4)Schicht ist.

## Revendications

1. Procédé de détermination du point final d'un stade d'attaque pendant une attaque en retrait d'une tranche semiconductrice ayant une couche formant masque au sommet d'un substrat dans une chambre d'attaque sous vide, le procédé comprenant les stades dans lesquels :
- on effectue un alignement de tranche à l'extrémité avant de chaque stade d'attaque ;
- on mesure l'épaisseur de la couche formant masque au sommet de la tranche en utilisant un système de mesure par laser, qui effectue une ellipsométrie tout en effectuant le stade d'alignement de tranche pour déterminer une valeur d'épaisseur représentant l'épaisseur de la couche formant masque ;
- on envoie la valeur d'épaisseur à un système de détermination interférométrique de point final effectuant un algorithme de point final ;
- on ajoute la valeur d'épaisseur à une valeur de profondeur cible, de l'algorithme de point final ;
- on ménage par attaque une cavité dans le substrat par rapport à un masque procuré par la couche formant masque ;
- on mesure la profondeur de la cavité pendant le stade d'attaque pour obtenir une valeur de profondeur représentant la profondeur de la cavité ;
- dans lequel on arrête le stade d'attaque lorsque la valeur de profondeur atteint la somme de la valeur de profondeur cible et de la valeur d'épaisseur.

2. Procédé suivant la revendication 1, **caractérisé en ce que** l'on effectue le stade de mesure de l'épaisseur alors que le système de mesure par laser est dirigé sur le centre de la tranche.

3. Procédé suivant l'une quelconque des revendications 1 à 2, **caractérisé en ce que** la couche formant masque est une couche de nitrure (4).
